# EUROPEAN PATENT APPLICATION

(11) **EP 4 513 536 A2**
(43) Date of publication of application: **26.02.2025**
(21) Application number: 24196145.7
(22) Date of filing: 23.08.2024
(51) Int. Cl.: H01L 21/677

(54) **SUBSTRATE PROCESSING APPARATUS, METHOD OF PROCESSING SUBSTRATE, METHOD OF MANUFACTURING SEMICONDUCTOR DEVICE, PROGRAM, AND CONTROL APPARATUS**

(30) Priority: 24.08.2023 JP 2023136276
(71) Applicant: Kokusai Electric Corporation, Tokyo 101-0045 (JP)
(72) Inventor: MORI, Shinichiro, Toyama-shi, Toyama, 939-2393 (JP)
(74) Representative: Bardehle Pagenberg Partnerschaft mbB Patentanwälte Rechtsanwälte

(57) **Abstract**

There is provided a technique that includes a controller configured to be capable of operating a first screen capable of displaying or operating apparatus information that is used in the substrate processing apparatus while at least one second screen capable of displaying at least one piece of related information which is related to the apparatus information is displayed on the first screen.

## Description

### CROSS-REFERENCE TO RELATED APPLICATION

This application is based upon and claims the benefit of priority from Japanese Patent Application No. 2023-136276, filed on August 24, 2023, the entire contents of which are incorporated herein by reference.

### TECHNICAL FIELD

The present disclosure relates to a substrate processing apparatus, a substrate processing method, a method of manufacturing a semiconductor device, a program, and a control apparatus.

### BACKGROUND

For example, in the related art, there is disclosed a substrate processing apparatus capable of displaying an operable sub-screen superimposed on a main screen that displays apparatus information used in the substrate processing apparatus.

### SUMMARY

By the way, when operating a substrate processing apparatus, a user does so on an operation screen. Therefore, an improvement in an efficiency of operations on the operation screen is desired.

Some embodiments of the present disclosure provide a technique capable of improving an efficiency of operations on a main screen where apparatus information used in a substrate processing apparatus may be displayed or operated.

According to some embodiments of the present disclosure, there is provided a technique that includes a controller configured to be capable of operating a first screen capable of displaying or operating apparatus information that is used in a substrate processing apparatus while at least one second screen capable of displaying at least one piece of related information which is related to the apparatus information is displayed on the first screen.

### BRIEF DESCRIPTION OF DRAWINGS

The accompanying drawings, which are incorporated in and constitute a part of the specification, illustrate embodiments of the present disclosure.
FIG. 1 is a perspective view schematically illustrating an example of a substrate processing apparatus according to some embodiments of the present disclosure.
FIG. 2 is a schematic configuration view of a process furnace in the substrate processing apparatus illustrated in FIG. 1.
FIG. 3 is a block diagram illustrating an example of a configuration of a control apparatus included in a substrate processing apparatus according to some embodiments of the present disclosure.
FIG. 4 is a block diagram illustrating an example of a functional configuration of a substrate processing apparatus according to some embodiments of the present disclosure.
FIG. 5 is a front view schematically illustrating an example of a first screen displayed on a display.
FIG. 6 is a front view illustrating an example of a state where a plurality of second screens are displayed on a first screen.
FIG. 7 is an enlarged view of an example of a second screen displayed on a first screen.
FIG. 8A is an enlarged view of another example of a second screen displayed on a first screen.
FIG. 8B is an enlarged view of another example of the second screen displayed on a first screen.
FIG. 9 is a front view illustrating another example of a state where a plurality of second screens are displayed on a first screen.
FIG. 10 is a flowchart illustrating an example of a flow of screen display processing according to the embodiment.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to unnecessarily obscure aspects of the various embodiments.

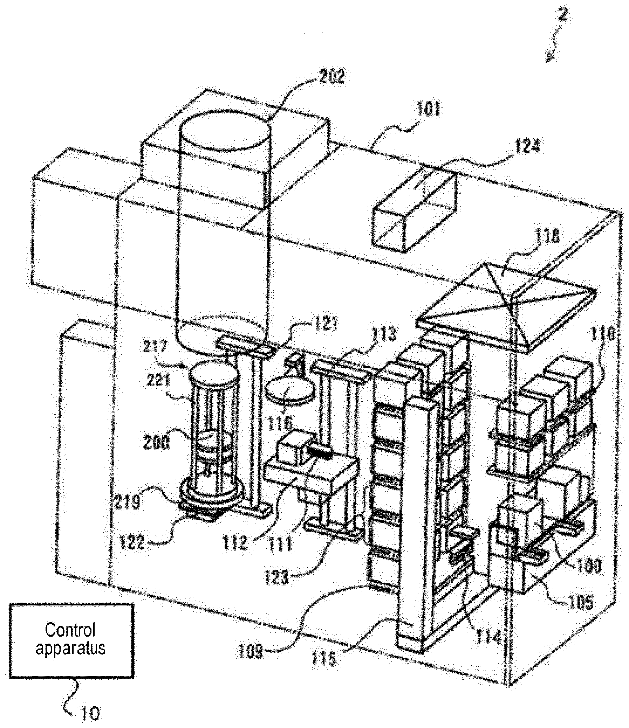

Hereinafter, some embodiments of the present disclosure will be described mainly with reference to FIGS. 1 to 10. In addition, the drawings used in the following description are schematic, and dimensional relationships, ratios, and the like of the respective components illustrated in the drawings may not match actual ones. Further, dimensional relationships, ratios, and the like of the respective components among plural drawings may not match one another. Further, the present disclosure is not limited to the following embodiments in any way, and modifications may be made within the scope of the present disclosure as appropriate.

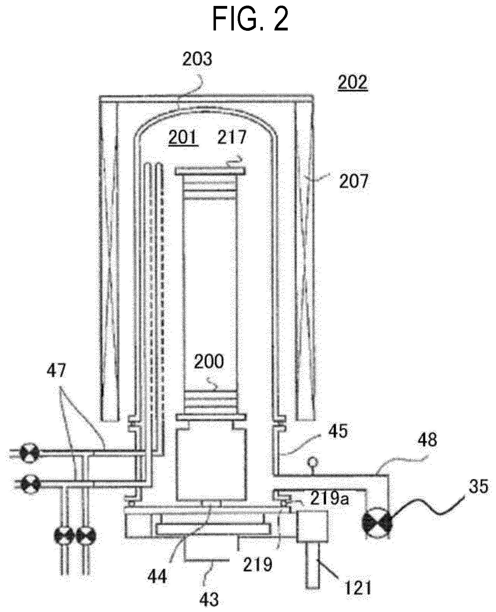

First, an outline of a substrate processing apparatus according to the embodiments of the present disclosure will be described with reference to FIGS. 1 and 2.

FIG. 1 is a perspective view schematically illustrating an example of a substrate processing apparatus 2 according to the embodiments of the present disclosure.

As illustrated in FIG. 1, the substrate processing apparatus 2 according to the embodiments includes a cassette 100, which accommodates a plurality of substrates 200 made of, e.g., silicon, and a housing 101. A cassette stage 105, which serves as a substrate container delivery stage, is installed inside the housing 101 at a cassette loading/unloading port (not illustrated). The cassette 100 is configured to be loaded onto the cassette stage 105 and to be unloaded from the cassette stage 105 by an in-process transporter (not illustrated).

A cassette shelf 109, which serves as a substrate container mounting shelf, is installed approximately at the center of the housing 101 in a front-rear direction. The cassette shelf 109 is configured to store a plurality of cassettes 100 in a plurality of rows and columns. The cassette shelf 109 is provided with a carriage shelf 123 where the cassettes 100 are stored. Further, a spare cassette shelf 110 is provided above the cassette stage 105 and is configured to temporarily store the cassettes 100. A cassette elevator 115, which is a substrate container lifting mechanism configured to be capable of moving up or down while holding the cassettes 100, and a cassette carrier 114 are provided between the cassette stage 105 and the cassette shelf 109. The cassette elevator 115 and the cassette carrier 114 are configured to, through continuous operations thereof, transport the cassettes 100 among the cassette stage 105, the cassette shelf 109, and the spare cassette shelf 110.

A substrate carrier 112 configured to be capable of rotating or linearly driving the substrates 200 in a horizontal direction and a carrier elevator 113 configured to raise or lower the substrate carrier 112 are provided behind the cassette shelf 109. The carrier elevator 113 is installed at a right end of the housing 101. The carrier elevator 113 and the substrate carrier 112 are configured to, through continuous operations thereof, charge or discharge the substrates 200 into or from a boat 217, which serves as a substrate holder, by using a tweezer 111, which is a substrate holding piece of the substrate carrier 112, as a mounter of the substrates 200.

A process furnace 202 is provided at a rear upper side of the housing 101. A lower end of the process furnace 202 is configured to be opened or closed by a furnace opening shutter 116, which serves as an opening/closing mechanism for a furnace opening. A boat elevator 121, which serves as a substrate holder lifting mechanism as a lifting mechanism configured to raise or lower the boat 217 into or from the process furnace 202 is provided below the process furnace 202. A seal cap 219, which serves as a lid, is horizontally placed at a lifter 122, which is a connector connected to a lifting stand of the boat elevator 121, such that the seal cap 219 is configured to vertically support the boat 217 and to be capable of closing a lower end of the process furnace 202. The boat 217 serving as a substrate holder includes a plurality of boat columns 221, and is configured to horizontally hold a plurality of wafers 200 (e.g., 50 or more and 150 or less substrates) with centers of the substrates 200 aligned with one another in a vertical direction.

As illustrated in FIG. 1, a cleaner 118 is provided above the cassette shelf 109 and is constituted by a supply fan and a dust-proof filter to supply clean air, which is an atmosphere purified from an external air inflow from a duct 124. Thus, the cleaner 118 is configured to circulate the clean air to the interior of the housing 101.

Next, an operation of the substrate processing apparatus 2 according to the embodiments of the present disclosure will be described. As illustrated in FIG. 1, the cassette 100 is loaded from the cassette loading/unloading port. The cassette 100 is automatically transported to a designated shelf position on either the cassette shelf 109 or the spare cassette shelf 110, where the cassette 100 is temporarily stored. Thereafter, the cassette 100 is carried from either the cassette shelf 109 or the spare cassette shelf 110 to the carriage shelf 123, or is directly transported to the carriage shelf 123.

Once the cassette 100 is carried onto the carriage shelf 123, the substrate 200 is picked up from the cassette 100 by the tweezer 111 of the substrate carrier 112 through a substrate entrance, and is charged into the boat 217. After delivering the substrate 200 to the boat 217, the substrate carrier 112 returns to the cassette 100 to charge the next substrate 200 into the boat 217.

Once a predetermined number of substrates 200 are charged into the boat 217, the lower end of the process furnace 202, which was closed by the furnace opening shutter 116, is opened by the furnace opening shutter 116. Subsequently, the boat 217 holding a group of substrates 200 is loaded into the process furnace 202 when the seal cap 219 is raised by the boat elevator 121.

After loading, the substrates 200 are subjected to arbitrary processing in the process furnace 202. After the processing, the substrates 200 and the cassette 100 are unloaded out of the housing 101 in the reverse procedure.

FIG. 2 is a schematic configuration view of the process furnace 202 in the substrate processing apparatus 2 illustrated in FIG. 1.

The process furnace 202 includes a reaction tube 203. The reaction tube 203 is made of, for example, a heat-resistant and non-metallic material such as quartz (SiO₂) or silicon carbide (SiC), and formed in a cylindrical shape with a closed upper end and an open lower end.

A process chamber 201 is formed inside the reaction tube 203. The boat 217 serving as a substrate holder is inserted from below into the process chamber 201, such that the substrates 200 held in a horizontal posture by the boat 217 are accommodated while being aligned with one another in multiple stages along a vertical direction. The boat 217 accommodated in the process chamber 201 is configured to be rotatable in a state where the plurality of substrates 200 are mounted on the boat 217, while maintaining an airtightness of the process chamber 201, when a rotating shaft 44 is rotated by a rotator 43.

A manifold 45 is arranged concentrically with the reaction tube 203 below the reaction tube 203. The manifold 45 is made of, for example, a metallic material such as stainless steel, and is formed in a cylindrical shape with open upper and lower ends. The reaction tube 203 is supported in a vertical orientation from the lower end side by the manifold 45. In other words, the reaction tube 203 forming the process chamber 201 is erected vertically via the manifold 45, thus constituting the process furnace 202. A lower end of the manifold 45 is configured to be airtightly sealed by the seal cap 219 when the boat elevator 121 moves up. A seal 219a such as an O-ring is provided between the lower end of the manifold 45 and the seal cap 219 to airtightly seal the process chamber 201.

Further, the manifold 45 is connected to each of a gas introduction pipe 47 configured to introduce, e.g., a precursor gas or a purge gas into the process chamber 201 and an exhaust pipe 48 configured to discharge the gas from the process chamber 201. A pressure of the process chamber 201 is controlled while an APC valve 35 is regulated based on detection results of a pressure sensor (not illustrated).

A heater 207, which serves as a heating mechanism, is arranged concentrically with the reaction tube 203 around an outer periphery of the reaction tube 203. The heater 207 is configured to heat the process chamber 201 so that a temperature distribution of the entire process chamber 201 becomes a uniform or predetermined temperature distribution.

Herein, as illustrated in FIG. 1, the substrate processing apparatus 2 includes a control apparatus 10 serving as a main controller, and the control apparatus 10 controls the substrate processing apparatus 2. The control apparatus 10 may be built into the substrate processing apparatus 2 or may be installed in an accessible manner outside the substrate processing apparatus 2. The control apparatus 10 controls, e.g., an operation of each component constituting the substrate processing apparatus 2 and the process furnace 202.

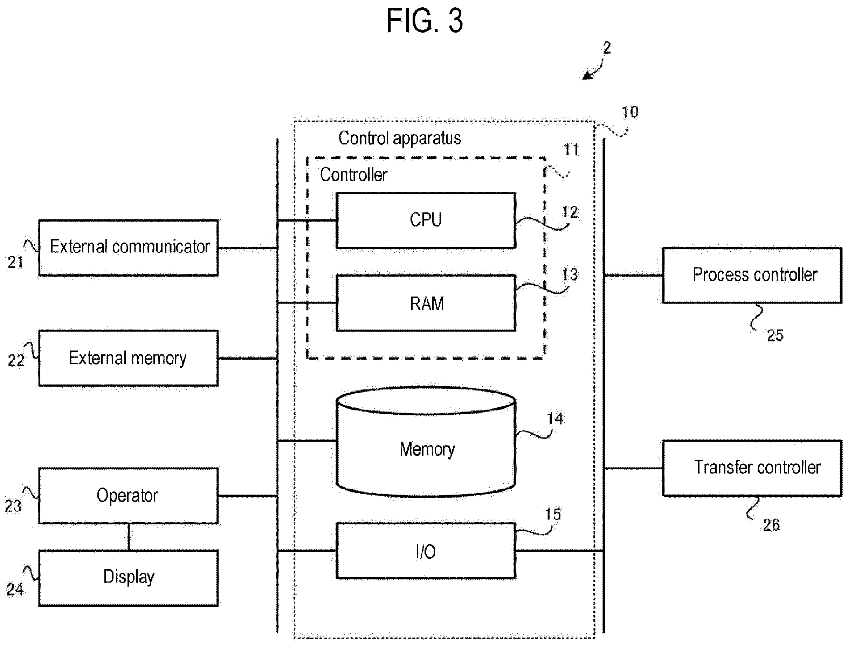

Next, a configuration of a control system of the substrate processing apparatus 2 according to the embodiments of the present disclosure will be described with reference to FIG. 3.

FIG. 3 is a block diagram illustrating an example of a configuration of the control apparatus 10 included in the substrate processing apparatus 2 according to the embodiments.

As illustrated in FIG. 3, the substrate processing apparatus 2 includes the control apparatus 10 serving as a main controller, an external communicator 21, an external memory 22, an operator 23, a display 24, a process controller 25, and a transport controller 26.

Further, the control apparatus 10 includes a controller 11, a memory 14, and an I/O (also referred to as "I/O port") 15. The controller 11 includes a central processing unit (CPU) 12 and a random access memory (RAM) 13.

The control apparatus 10 is connected to the operator 23 and is also connected to the process controller 25 and the transport controller 26 via the I/O 15. Being electrically connected to each of the process controller 25 and the transport controller 26 via the I/O 15, the control apparatus 10 is configured to be capable of performing, e.g., transmission and reception of each data or downloading and uploading of each file.

The control apparatus 10 is connected to an external host computer (not illustrated) via the external communicator 21. Therefore, even in a case where the substrate processing apparatus 2 is installed in a clean room, the host computer may be located outside the clean room such as in an office. Further, the control apparatus 10 is connected to the external memory 22, which serves as a mount into which a universal serial bus (USB) memory, etc. as an example of a recording medium is detachably inserted.

The operator 23 is integrated with the display 24, or is connected to the display 24 via, e.g., a video cable. The display 24 is, for example, a liquid crystal display panel. The display 24 is configured to display each operation screen configured to operate the substrate processing apparatus 2. The operation screen includes a screen configured to monitor statuses of a substrate process system controlled by the process controller 25 and a substrate transport system controlled by the transport controller 26. The display 24 may be further provided with each operation button as an input component to input operational instructions for the substrate process system and the substrate transport system. The operator 23 enables the display 24 to display information generated in the substrate processing apparatus 2 through the operation screen. Further, the operator 23 enables, for example, the output of the information displayed on the display 24 to a device such as a USB memory inserted into the external memory 22. The operator 23 receives input data (input instructions) from the operation screen displayed on the display 24, and transmits the input data to the control apparatus 10. Further, the operator 23 is configured to receive instructions (control instructions) to execute an arbitrary substrate processing recipe (also referred to as "process recipe") among a plurality of recipes stored in the memory 14 or a recipe developed in the RAM 13 and to transmit the instructions to the control apparatus 10. In addition, the operator 23 and the display 24 may be configured with a touch panel. Herein, the operator 23 and the display 24 are provided separately from the control apparatus 10 but may be integrally included in the control apparatus 10.

The process controller 25, although not illustrated herein, includes a temperature controller, a gas flow rate controller, and a pressure controller. Each of the temperature controller, the gas flow rate controller, and the pressure controller constitutes a sub-controller and is electrically connected to the process controller 25, enabling transmission and reception of each data, downloading and uploading of each file, or the like. In addition, the process controller 25 and each sub-controller (temperature controller, gas flow rate controller, and pressure controller) may be configured separately or integrally.

The transport controller 26, although not illustrated herein, includes a mechanism controller. The mechanism controller is configured to control each of a drive system, a rotator system, and a lifting system of the substrate processing apparatus 2. The transport controller 26 is configured to control a transport operation of each transport mechanism included in the substrate processing apparatus 2.

In addition, the processing of the substrate 200 is performed, for example, according to a recipe that defines a processing condition for the substrate 200. The recipe is stored in the memory 14, and the controller 11 acquires the stored recipe during substrate processing, thus controlling the substrate processing based on the processing condition defined in the recipe. The recipe may be stored in the external memory 22 as well as the memory 14. Examples of the external memory 22 include a USB memory, compact disc (CD), digital versatile disc (DVD), and external hard disk. Further, the recipe may be acquired from an external device via the external communicator 21.

In addition, the control apparatus 10, the process controller 25, and the transport controller 26 according to the embodiments are not limited to a dedicated system and may be realized by using a conventional computer system. For example, each controller configured to execute a predetermined processing may be configured by installing a program for executing the above-described processing from a recording medium (such as CD-ROM or USB) storing that program to a general-purpose computer.

Then, there is an arbitrary way of supplying these programs. The programs may be supplied through a predetermined recording medium as described above, or may be supplied through, for example, communication lines, communication networks, and communication systems.

The control apparatus 10 is constituted as a computer equipped with the CPU 12, RAM 13, memory 14, and I/O 15. The memory 14 stores, e.g., each recipe file for recipes that define processing conditions and processing procedures, a control program file for executing each recipe file, a parameter file (setting value file) for setting processing conditions and processing procedures, an error-processing program file, an error-processing parameter file, a file for various screens including an input screen configured to input processing parameters, and a file for various icons (none of which are illustrated). In addition, the control apparatus 10 is connected to a network such as the Internet, local area network (LAN), or wide area network (WAN) by using the external communicator 21, thus enabling communication with external devices via the network.

Further, the memory 14 may be, for example, a hard disk drive (HDD), solid state drive (SSD), or flash memory. The memory 14 stores a screen display processing program for executing a screen display processing according to the embodiments of the present disclosure.

The screen display processing program may be installed in advance in the substrate processing apparatus 2, for example. The screen display processing program may be realized by being recorded on a non-volatile recording medium or being distributed via a network, and appropriately being installed in the substrate processing apparatus 2. In addition, examples of the non-volatile recording medium include a compact disc read only memory (CD-ROM), magneto-optical disk, HDD, digital versatile disc read only memory (DVD-ROM), flash memory, memory card, and USB.

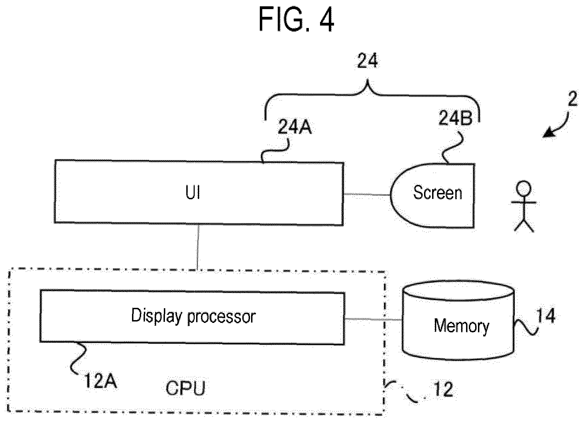

The CPU 12 of the substrate processing apparatus 2 according to the embodiments of the present disclosure functions as a display processor 12A illustrated in FIG. 4 by writing the screen display processing program stored in the memory 14 into the RAM 13 and executing the same.

FIG. 4 is a block diagram illustrating an example of a functional configuration of the substrate processing apparatus 2 according to the embodiments of the present disclosure.

As illustrated in FIG. 4, the display 24 includes a user interface (UI) 24A and a screen 24B. The UI 24A acquires at least a part of information displayed on the screen 24B as image data and transmits the same to the screen 24B. Further, the UI 24A receives inputs from the user and processes the same. The screen 24B presents the image data transmitted from the UI 24A to the user.

The display 24 may display a first screen and at least one second screen. The first screen is a main screen (also referred to as a "parent screen"), and the second screen is a sub screen (also referred to as a "child screen"). The first screen is a screen where apparatus information used in the substrate processing apparatus 2 may be displayed or operated. For example, the first screen enables buttons on the screen to be operated, thus enabling editing of recipes, parameters, and the like. The apparatus information displayed on the first screen includes, for example, information indicating a state of the substrate processing apparatus 2 and information including recipes, parameters, etc. to be edited. On the other hand, the at least one second screen is a screen where at least one piece of related information which is related to the apparatus information on the first screen may be displayed. For example, the second screen displays captured images of at least part of the first screen, pre-stored images, text messages, videos, and the like. The related information displayed on the second screen includes, for example, apparatus information described in the captured images and text messages.

The display processor 12A enables the first screen of the display 24 to be operated while the second screen displaying the related information is displayed on the first screen. In other words, while the second screen displaying the related information is displayed as superimposed on the first screen, the display processor 12A enables operations on the first screen, for example, pressing buttons, operating scroll bars, editing data such as inputting or modifying data, and the like. In addition, the display processor 12A enables processing such as loading, saving, and renaming image files stored in the memory 14. The display processor 12A enables addition or deletion of text, images, and the like on image data such as captured images. This enables the first screen to be operated while comparing the apparatus information on the first screen with the related information on the second screen on the same screen, for example, on the same display screen.

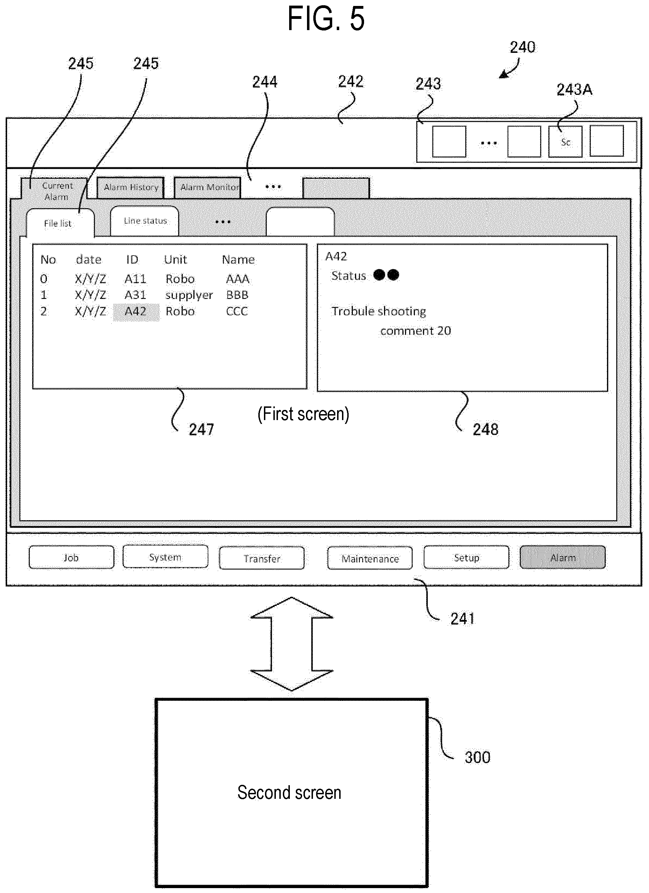

FIG. 5 is a front view schematically illustrating an example of a first screen 240 displayed on the display 24.

The first screen 240 illustrated in FIG. 5 includes a navigation panel 241, a title panel 242, and an apparatus information display area 244. The first screen 240 is a screen configured to display apparatus information used in the substrate processing apparatus 2 and is structured hierarchically.

The navigation panel 241 includes a plurality of buttons arranged to designate the first screen 240 to be displayed. The navigation panel 241 is an area where the plurality of buttons are fixed. The plurality of buttons arranged on the navigation panel 241 include, for example, a "Job" button, a "System" button, a "Transfer" button, a "Maintenance" button, a "Setup" button, and an "Alarm" button. When any one of the plurality of buttons arranged on the navigation panel 241 is pressed, transition to a screen of corresponding apparatus information 245 occurs.

Specifically, when the "Job" button is selected, transition to a screen displaying apparatus information regarding a job occurs. When the "System" button is selected, transition to a screen displaying apparatus information regarding a system occurs. When the "Transfer" button is selected, transition to a screen displaying apparatus information regarding substrate transport occurs. When the "Maintenance" button is selected, transition to a screen displaying apparatus information regarding maintenance occurs. When the "Setup" button is selected, transition to a screen displaying apparatus information regarding setup occurs. When the "Alarm" button is selected, transition to a screen displaying apparatus information regarding an alarm occurs. In the example of FIG. 5, the "Alarm" button is selected, corresponding apparatus information is displayed.

The title panel 242 is an area configured to display information regarding the entire system. A button arrangement area 243 is fixedly provided in the title panel 242. The button arrangement area 243 includes, for example, a screen shot (Sc) button 243A. The Sc button 243A is a button for instructing a screenshot and is an example of an instructor. The screenshot is, for example, a function of storing the apparatus information as image data and a function of capturing at least a partial area of the first screen. An image acquired with the "screenshot" may be displayed, for example, as a sub screen superimposed on the main screen. In addition to the Sc button 243A, the button arrangement area 243 includes a Me button for instructing the display of messages, a Ta button for instructing the execution of tasks, a Pr button for switching between English text and Japanese text, and the like.

The apparatus information display area 244 is at the same hierarchical level as each button of the navigation panel 241 and displays the apparatus information 245 to be edited. In other words, the navigation panel 241 and the apparatus information display area 244 are displayed at a first hierarchical area, while the apparatus information 245 is displayed at a second hierarchical area.

In the example of FIG. 5, since the "Alarm" button of the navigation panel 241 is selected, the apparatus information 245 corresponding to the "Alarm" button is displayed. The apparatus information 245 includes various items such as "Current Alarm," "Alarm History," "Alarm Monitor," and so on. These items such as "Current Alarm," "Alarm History," "Alarm Monitor," and so on may be switched and displayed by using tags.

In the example of FIG. 5, since the "Current Alarm" tag is selected, the apparatus information 245 corresponding to the "Current Alarm" tag is displayed at a third hierarchical area. The apparatus information 245 includes various items such as "File list," "Line status," and so on. These items such as "File list, "Line status," and so on may be switched and displayed by using tags. Herein, the "File list" tag is selected, so that a file list 247 to be edited is displayed. Then, a "A42" file of the displayed file list 247 is selected, and alarm information 248 corresponding to "A42" is displayed.

A second screen 300 displays related information which is related to the apparatus information on the first screen 240. The display processor 12A enables the first screen 240 to be operable while the second screen 300 displaying the related information is displayed on the first screen 240. Specifically, with the second screen 300 displayed on the first screen 240, the display processor 12A enables operations such as operating various buttons arranged on each of the navigation panel 241 and the title panel 242 or editing various pieces of information on the first screen 240.

The Sc button 243A may instruct, for example, creation of a copied image (i.e., a captured image) of the first screen 240. In this case, the related information displayed on the second screen 300 is a copied image of the first screen 240 created in response to an instruction by the Sc button 243A. This enables the creation of a captured image of the first screen 240 by using a simple method. In addition, the captured image acquired from the first screen 240 may be captured by designating a range of the entire first screen 240 but may be captured by designating a range of a portion of the first screen 240.

Further, the memory 14 may store the copied image of the first screen 240 as the related information. In addition, when storing the related information in the memory 14, it is desirable to associate the information with pre-designated information on the first screen 240. The pre-designated information on the first screen 240 includes, for example, item names of the navigation panel 241 and names of hierarchies under those item names. As an example, in a case where "Maintenance" of the navigation panel 241 is selected and "monitor" is selected from "monitor," "editor," and "log," which are hierarches under that item, "Maintenance" and "monitor" would be associated as the pre-designated information on the first screen 240. Further, in addition to the item names and the names of hierarchies, the information may also be associated with the date and time the captured image is created. This makes it easier to select the related information when reading the related information later. Specifically, when the information is associated with the date and time, it is possible to track a history such as an alarm along a timeline, thereby improving an efficiency of image operations.

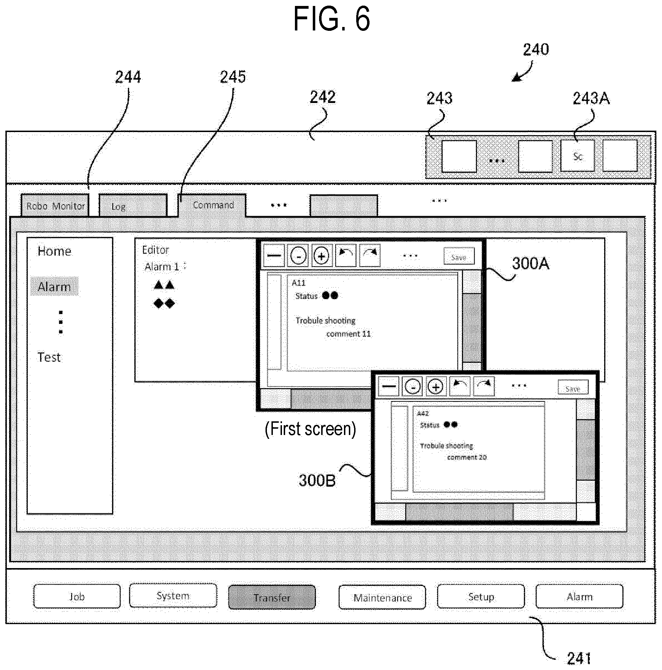

Further, the memory 14 may be configured to store a plurality of pieces of related information. The display processor 12A reads the related information from the memory 14 and displays the read related information on the second screen 300. This enables reading and referring to a plurality of pieces of related information at a desired timing. The related information may be images obtained by capturing at least a partial area of the first screen 240. For example, as illustrated in FIG. 6, a plurality of second screens 300A and 300B obtained by capturing at least a partial area of the first screen 240 may be displayed on the first screen 240.

FIG. 6 is a front view illustrating an example of a state where the plurality of second screens 300A and 300B are displayed on the first screen 240. The first screen 240 illustrated in FIG. 6 is a screen where the "Transport" button of the navigation panel 241 is selected and displayed. For example, when the "Transport" button of the navigation panel 241 is selected with the plurality of second screens 300A and 300B displayed on the first screen 240 including the apparatus information 245 illustrated in FIG. 5 described above, transition to a screen of the apparatus information 245 illustrated in FIG. 6 occurs. In other words, even when the first screen 240 is operated to enable transition of the screen of the apparatus information 245, the plurality of second screens 300A and 300B remain displayed on the first screen 240 as they are.

In FIG. 6, the second screen 300A at the upper side, i.e., near the title panel 242, is an image obtained by capturing alarm information corresponding to "A11" of the file list 247 illustrated in FIG. 5, and the second screen 300B at the lower side, i.e., near the navigation panel 241 is an image obtained by capturing alarm information corresponding to "A42" of the file list 247 illustrated in FIG. 5.

When considering the entire areas of the first screen 240 as related information, it becomes possible to record information on the first screen 240 without omission and refer to the same on any screen. Further, when considering a partial area of the first screen 240 as related information, it becomes possible to immediately identify a location to be reviewed when reading that information from the memory 14 at a later time.

Further, the related information displayed on the second screen 300 may be previously stored information from previous operations. Examples of the previously stored information from previous operations include initial setup data stored at a factory before shipping to a customer and data of experiments conducted by the customer after delivery to the customer.

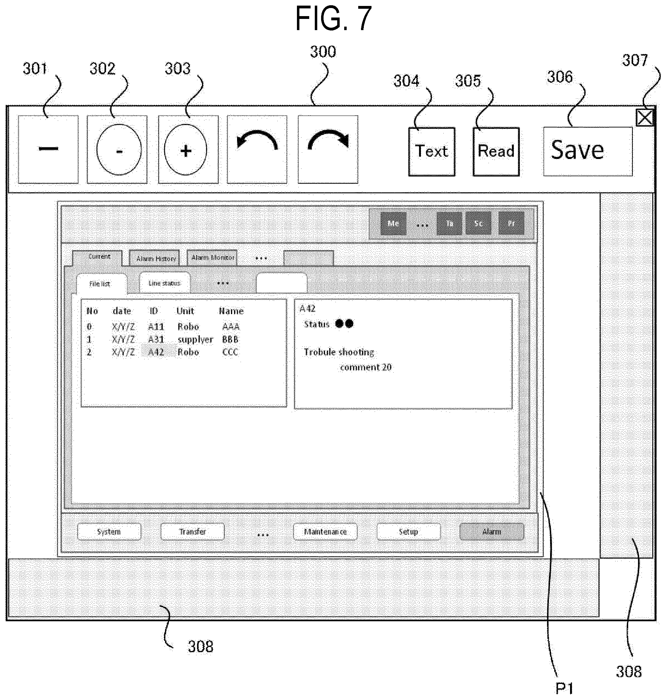

FIG. 7 is an enlarged view of an example of the second screen 300 displayed on the first screen 240.

As illustrated in FIG. 7, at least one selected from the group of the second screen 300 and the related information may be enlarged or reduced for display.

As an example, a captured image P1 of the first screen 240 is displayed as related information on the second screen 300 illustrated in FIG. 7. The second screen 300 is provided with a minimizing button 301 to minimize the second screen 300, a reducing button 302 to reduce the captured image P1, a enlarging button 303 to enlarge the captured image P1, a "Text" button 304 to add text information to the captured image P1, a "Read" button 305 to read and display new image data from the memory 14, a "Save" button 306 to save the captured image P1, a close button 307 to close the second screen 300, and a scrollbar 308 to scroll through the captured image P1. The reducing button 302 and the enlarging button 303 enable the capture image P1 to be reduced or enlarged. This facilitates easy comparison between the item of the first screen 240 to be reviewed and the information on the second screen 300. Further, for example, the second screen 300 may be enlarged or reduced by dragging a frame around the second screen 300.

Further, the second screen 300 may be movable on the first screen 240. In other words, it becomes possible to move the second screen 300 closer to the item of the first screen 240 to be reviewed. For example, a method of dragging and moving the second screen 300 is used. This facilitates easy comparison between the item of the first screen 240 to be reviewed and the information on the second screen 300.

Herein, as an example, the related information displayed on the second screen 300 is information indicating an alarm content regarding the substrate processing apparatus 2 as illustrated in FIG. 6 described above, or information describing the item displayed on the first screen 240. For example, the first screen 240 may be operated to enable transition to a display screen regarding an alarm while displaying information indicating the alarm content on the second screen 300. In addition, examples of the information describing the item displayed on the first screen 240 include help information for the item or information indicating description of terms or description of operations.

Further, the related information displayed on the second screen 300 may be information indicating a plurality of alarm contents regarding the substrate processing apparatus 2, or information describing a plurality of items displayed on the first screen 240. In this case, the first screen 240 remains operable while a plurality of second screes 300 displaying the information indicating the alarm contents or a plurality of second screens 300 displaying the information describing the items displayed on the first screen 240 on are displayed on the first screen 240. For example, in a case where each alarm is associated with a plurality of factors, the first screen 240 may be operated to enable transition to a display screen regarding the alarm while displaying information indicating the alarm contents on the plurality of second screens 300.

Further, the information indicating the alarm content may be information related to, for example, troubleshooting set for each alarm or for each information describing the item. This enables efficient troubleshooting since transition to various display screens is possible while performing a comparison with a plurality of pieces of information related to troubleshooting.

Further, recipe information (main recipe information or sub-recipe information) that defines a processing condition for the substrate 200 may be displayed on the first screen 240. Then, the related information displayed on the second screen 300 may be at least one piece of information related to the recipe information. In this case, the first screen 240 remains operable while one or more second screens 300 displaying the information related to the recipe information are displayed on the first screen 240. This enables efficient confirmation and editing of the recipe information since it is possible to check the recipe information on the first screen 240 while displaying the information related to the recipe information on the second screens 300.

Further, the related information displayed on the second screens 300 may be sub-recipe information or main recipe information linked to the recipe information (main recipe information or sub-recipe information) of the first screen 240. This enables checking and editing main recipe information on the first screen 240 while displaying sub-recipe information on the second screen 300. Alternatively, it is also possible to check and edit sub-recipe information on the first screen 240 while displaying main recipe information on the second screen 300.

Further, the first screen 240 may display parameter information of the substrate processing apparatus 2. Then, the second screen 300 may display comparative parameter information for comparison with the parameter information. The parameter information on the first screen 240 is real-time information obtained from the substrate processing apparatus 2, and the comparative parameter information on the second screen 300 is pre-stored information for comparison. This enables comparing the parameter information on the first screen 240 with the comparative parameter information on the second screen 300, facilitating easy understanding of the status of the apparatus.

Further, the display processor 12A may set a plurality of authorities for apparatus information, and may set a browsing or operation authority of the apparatus information for each authority thus set. In addition, as an example, the authority referred to herein is set for customer's supervisor, customer's person in charge, or apparatus manufacturer's person in charge. For example, by enabling the customer's supervisor and the customer's person in charge to browse the apparatus information while disabling the apparatus manufacturer's person in charge from browsing the apparatus information, the apparatus manufacturer's person in charge is unable to browse the parameter information known to the customer alone. As described above, by enabling browsing or operating of the apparatus information for each authority, appropriate information management for each authority becomes possible.

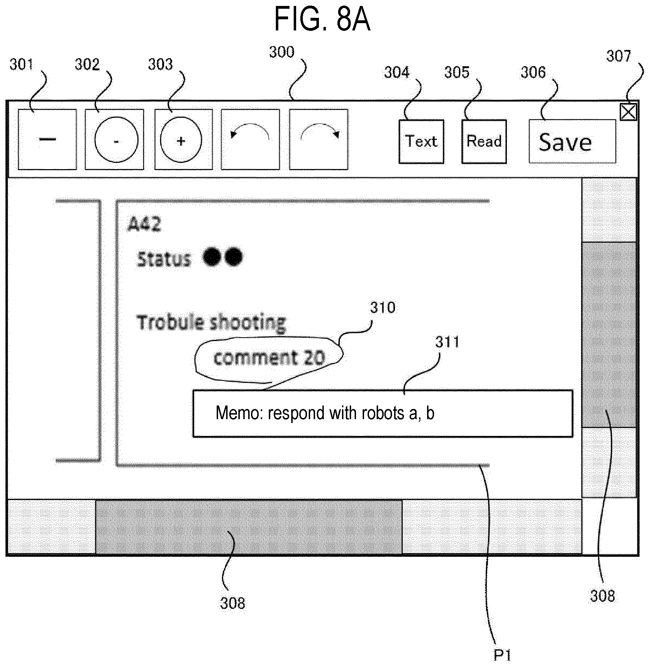

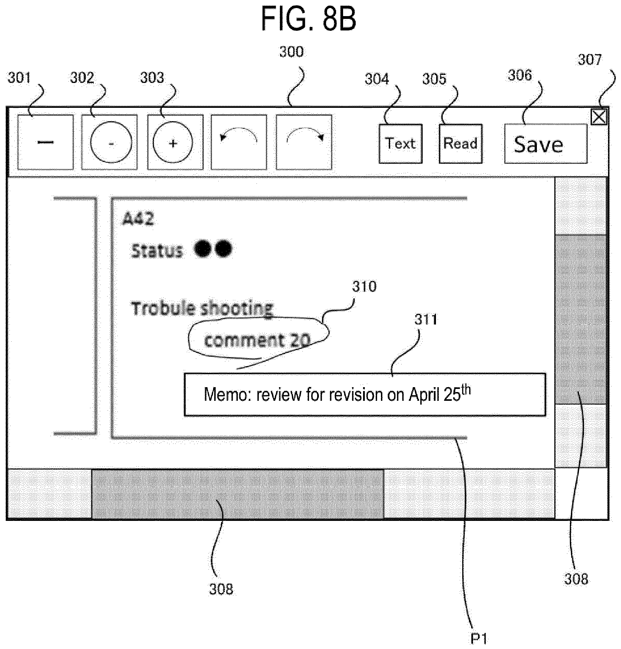

FIGS. 8A and 8B are enlarged views of other examples of the second screen 300 displayed on the first screen 240.

The display processor 12A may add new information to the related information displayed on the second screen 300. Adding new information may be performed, for example, by pressing the "Text" button 304. The new information referred to herein is, for example, text information or attention-requiring information. Specifically, as illustrated in FIGS. 8A and 8B, an enclosure line 310 may be added an example of attention-requiring information or a memo 311 may be added as an example of text information. In addition to the enclosure line 310, the attention-requiring information may include, for example, circles, underlines, checkmarks, markings, etc. By adding the enclosure line 310 or the memo 311 to the captured image P1 as the related information, it is possible to easily understand the previous state when the captured image P1 is read next.

Further, in addition to the image, the related information displayed on the second screen 300 may include text information. Since the second screen 300 may be used as a text message for the user (worker), it is possible to enhance a work efficiency.

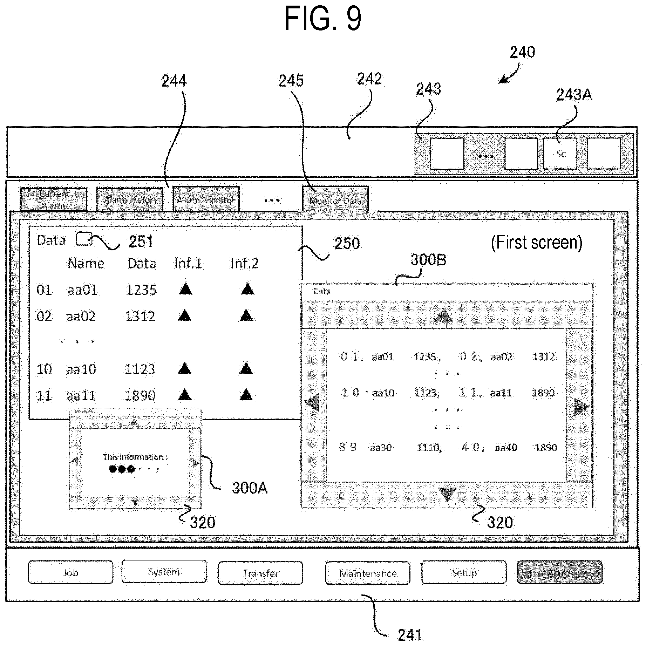

FIG. 9 is a front view illustrating another example of a state where the plurality of second screens 300A and 300B are displayed on the first screen 240. The first screen 240 illustrated in FIG. 9 is a screen where the "Alarm" button of the navigation panel 241 is selected and a "Monitor Data" tag is selected and displayed.

In FIG. 9, the first screen 240 displays a monitor data list 250. The monitor data list 250 includes an information button 251. When the information button 251 is pressed, the second screen 300A is displayed on the first screen 240. The second screen 300A includes movement buttons 320 as an example of a button accepting a user touch operation to instruct the movement of the second screen 300A. The movement buttons 320 are provided at upper, lower, right, and left sides of the second screen 300A and are capable of moving the second screen 300A vertically and horizontally. The movement buttons 320 accept a touch operation even when the user is wearing gloves, enabling the movement of the second screen 300A.

Related information which is related to the monitor data list 250 is displayed on the second screen 300B. The related information displayed on the second screen 300B is monitor data indicating an operational status of the substrate processing apparatus 2. In this case, it is possible to perform editing on the first screen 240 while viewing the monitor data. Similar to the second screen 300A, the second screen 300B includes the movement buttons 320 as an example of a button accepting a user touch operation to instruct the movement of the second screen 300B. The movement buttons 320 are provided at upper, lower, right, and left sides of the second screen 300B and are capable of moving the second screen 300B vertically and horizontally. The movement buttons 320 accepts a touch operation even when the user is wearing gloves, enabling the movement of the second screen 300B.

The monitor data list 250 of the first screen 240 displays monitor data names, which are the names of monitor data indicating the operational status of the substrate processing apparatus 2, and a plurality of items regarding the monitor data names. Herein, "aa01" to "aa11" of the monitor data list 250 are an example of the monitor data names. Then, the second screen 300B display the monitor data names and some items among the plurality of items. In some cases, the monitor data list 250 of the first screen 240 may not be able to display the entire data due to screen size constraints. In the example of FIG. 9, the monitor data list 250 of the first screen 240 lists monitor data "aa01" to "aa11," although the monitor date list 250 includes, for example, from "aa01" to "aa40." In contrast, the second screen 300B displays the entire monitor data names from "aa01" to "aa40" but extracts and displays some items (herein, item "Data") among the plurality of items of the monitor data list 250. This enables the second screen 300B to display some of the monitor data names and items that may not be fully displayed on the first screen 240, enabling an editing operation.

Further, the second screen 300B may be configured to display a list of the monitor data names. In other words, in this case, the plurality of items included in the monitor data list 250 are not displayed on the second screen 300B. This enables the second screen 300B to display a list of the monitor data names that may not be fully displayed on the first screen 240, enabling an editing operation. Further, the items displayed on the second screen 300B may be appropriately selected by the user. This enables displaying information that matches the user's purpose, facilitating easy understanding of desired information.

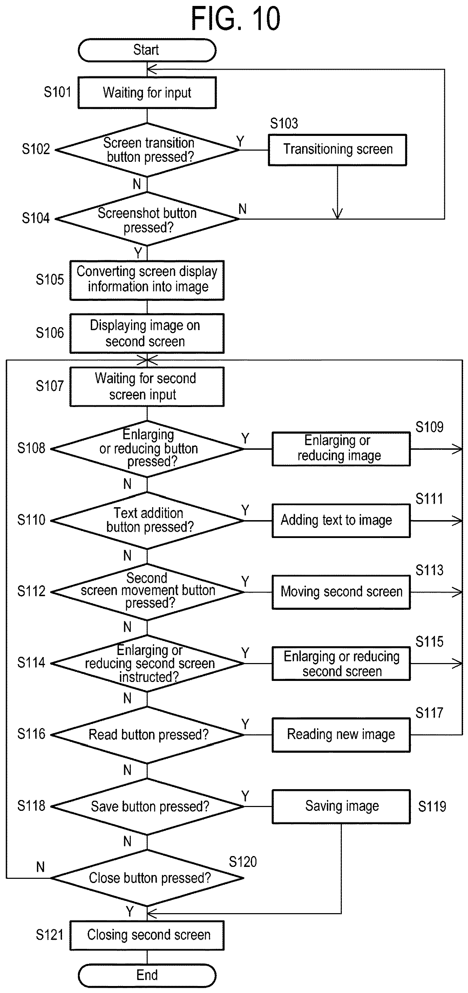

Next, an action of the substrate processing apparatus 2 according to the embodiments of the present disclosure will be described with reference to FIG. 10.

FIG. 10 is a flowchart illustrating an example of a flow of screen display processing according to the embodiments of the present disclosure.

In step S101 of FIG. 10, the CPU 12 causes the display 24 to display, for example, the first screen 240 illustrated in FIG. 5 as described above and to wait for a user input.

In step S102, the CPU 12 determines whether a screen transition button (e.g., various buttons arranged on the navigation panel 241) is pressed for the first screen 240. When the CPU 12 determines that the screen transition button is pressed (affirmative determination), it proceeds to step S103. When the CPU 12 determines that the screen transition button is not pressed (negative determination), it proceeds to step S104.

In step S103, the CPU 12 transitions to a screen corresponding to the screen transition button pressed in step S102, and returns to step S101 to repeat the processing.

On the other hand, in step S104, the CPU 12 determines whether a screenshot button (e.g., the Sc button 243A) is pressed. When the CPU 12 determines that the screenshot button is not pressed (negative determination), it returns to step S101 to repeat the processing. When the CPU 12 determines that the screenshot button is pressed (affirmative determination), it proceeds to step S105.

In step S105, the CPU 12 converts, for example, at least part of apparatus information displayed on the first screen 240 illustrated in FIG. 5 as described above into image data.

In step S106, the CPU 12 displays the image data converted in step S105 on the second screens 300A and 300B, for example, as illustrated in FIG. 6 described above, and displays the second screens 300A and 300B on the first screen 240.

In step S107, the CPU 12 causes, for example, the second screen 300 illustrated in FIG. 7 as described above to wait for a user input.

In step S108, the CPU 12 determines whether an enlarging or reducing button (e.g., the reducing button 302 or the enlarging button 303) is pressed for the captured image P1 of the second screen 300, for example, as illustrated in FIG. 7 described above. When the CPU 12 determines that the enlarging or reducing button is pressed (affirmative determination), it proceeds to step S109. When the CPU 12 determines that the enlarging or reducing button is not pressed (negative determination), it proceeds to step S110.

In step S109, the CPU 12 performs an operation of enlarging or reducing the captured image P1, and then returns to step S107 to repeat the processing.

On the other hand, in step S110, the CPU 12 determines whether a text addition button (e.g., the "Text" button 304) is pressed for the captured image P1 of the second screen 300. When the CPU 12 determines that the text addition button is pressed (affirmative determination), it proceeds to step S111. When the CPU 12 determines that the text addition button is not pressed (negative determination), it proceeds to step S 112.

In step S111, the CPU 12 adds text (e.g., the memo 311) to the captured image P1, for example, as illustrated in FIGS. 8A and 8B, and then returns to step S107 to repeat the processing.

On the other hand, in step S 112, the CPU 12 determines whether a second screen movement button (e.g., the movement button 320) is pressed for either the second screen 300A or the second screen 300B, for example, as illustrated in FIG. 9. When the CPU 12 determines that the second screen movement button is pressed (affirmative determination), it proceeds to step S113. When the CPU 12 determines that the second screen movement button is not pressed (negative determination), it proceeds to step S 114.

In step S113, the CPU 12 moves the second screen 300A or 300B in response to the user's touch operation, and then returns to step S107 to repeat the processing.

On the other hand, in step S114, the CPU 12 determines whether the operation of enlarging or reducing is instructed for either the second screen 300A or 300B, for example, as illustrated in FIG. 9 described above. When the CPU 12 determines that the operation of enlarging or reducing is instructed (affirmative determination), it proceeds to step S115. When the CPU 12 determines that the operation of enlarging or reducing is not instructed (negative determination), it proceeds to step S116.

In step S115, the CPU 12 performs the operation of enlarging or reducing the second screen 300A or 300B, and then returns to step S107 to repeat the processing.

On the other hand, in step S116, the CPU 12 determines whether a read button (e.g., the "Read" button 305) for instructing reading of new image data from the memory 14 is pressed, for example, as illustrated in FIG. 7 described above. It is determined whether the read button is pressed. When the CPU 12 determines that the read button is pressed (affirmative determination), it proceeds to step S117. When the CPU 12 determines that the read button is not pressed (negative determination), it proceeds to step S118.

In step S117, the CPU 12 reads new image data from the memory 14 in response to a user's operation, displays the same on the second screen 300, and then returns to step S107 to repeat the processing.

On the other hand, in step S118, the CPU 12 determines whether a save button (e.g., the "Save" button 306) is pressed for the captured image P1 of the second screen 300, for example, as illustrated in FIG. 7 described above. When the CPU 12 determines that the save button is pressed (affirmative determination), it proceeds to step S119. When the CPU 12 determines that the save button is not pressed (negative determination), it proceeds to step S120.

In step S119, the CPU 12 stores the captured image P1 of the second screen 300 in the memory 14, and then proceeds to step S121.

On the other hand, in step S120, the CPU 12 determines whether a close button (e.g., the close button 307) is pressed for the second screen 300, for example, as illustrated in FIG. 7 described above. When the CPU 12 determines that the close button is pressed (affirmative determination), it proceeds to step S121. When the CPU 12 determines that the close button is not pressed (negative determination), it returns to step S107 to repeat the processing.

In step S121, the CPU 12 performs an operation of closing the second screen 300 and terminating the screen display processing.

Next, a method of processing a substrate, which uses the substrate processing apparatus 2, will be described. These processes are controlled by the controller 11 based on content of a preset recipe. Once the boat 217 charged with the plurality of substrates 200 is loaded into the process chamber 201, the interior of the process chamber 201 is maintained at a predetermined pressure and temperature, and a predetermined gas is supplied into the process chamber 201 via the gas introduction pipe 47.

The gas introduced via the gas introduction pipe 47 is used to process each substrate 200. For example, the gas is used to form a film on the substrate 200. After a predetermined time elapses, the supply of gas via the gas introduction pipe 47 is stopped, and the substrate processing is terminated. After processing the substrate 200 is completed, the boat 217 is unloaded from the process chamber 201.

In addition, the embodiments of the present disclosure may employ a method of processing a substrate, which includes: for the display 24, operating the first screen 240 while the second screen 300 displaying the related information is displayed on the first screen 240; and loading the substrate 200 into the substrate processing apparatus 2 with the first screen 240 operated.

Further, the embodiments of the present disclosure may employ a method of manufacturing a semiconductor device, which includes processing the substrate 200 in the process chamber 201 included in the substrate processing apparatus 2.

As described above, according to the embodiments, a main screen (first screen) remains operable while a sub-screen (second screen) displaying the related information is displayed on the main screen. This enables, e.g., editing of apparatus information on the main screen while viewing the related information on the sub screen, resulting in an improvement in an efficiency of operations on the main screen.

The substrate processing apparatus and the control apparatus according to some embodiments of the present disclosure are described above by way of example. The embodiments may also a form of programs that causes a computer to execute functions of the substrate processing apparatus and the control apparatus. The embodiments may also a form of a non-transitory recording medium readable by the computer storing these programs.

Moreover, the configurations of the substrate processing apparatus and the control apparatus described in the embodiments are given by way of example and may be modified according to situations within the scope without departing from the gist of the present disclosure.

Further, the processing flow of the programs described in the above embodiments are also given by way of example, and some steps may be deleted, new steps may be added, or the processing sequence may be changed within the scope without departing from the gist of the present disclosure.

Further, in the above embodiments, a case where the processing of the embodiments are realized by a software configuration by using a computer through the execution of programs is described, but the embodiments are not limited thereto. The embodiments may be realized, for example, by a hardware configuration or a combination of hardware and software configurations.

In the above embodiments, an example of performing a predetermined processing on a substrate surface by using a batch-type substrate processing apparatus configured to process a plurality of substrates at once. The present disclosure is not limited to the above-described embodiments, and for example, may be suitably applied to a case where a predetermined processing is performed on the substrate surface by using single-wafer type substrate processing apparatus configured to process one or several substrates at once. Further, in the above-described embodiments, an example of performing a predetermined processing on the substrate surface by using a substrate processing apparatus including a hot-wall-type process furnace is described. The present disclosure is not limited to the above-described embodiments, and may be suitably applied to a case where a predetermined processing is performed on the substrate surface by using a substrate processing apparatus including a cold-wall-type process furnace as well.

Even when using such a substrate processing apparatus, it is possible to perform each processing by using the same processing procedures and processing conditions as in the above-described embodiments, and to achieve the same effects as the above-described embodiments.

According to the present disclosure in some embodiments, it is possible to improve an efficiency of operations on a main screen where apparatus information used in a substrate processing apparatus may be displayed or operated.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A substrate processing apparatus comprising a controller configured to be capable of operating a first screen capable of displaying or operating apparatus information that is used in the substrate processing apparatus while at least one second screen capable of displaying at least one piece of related information which is related to the apparatus information is displayed on the first screen.

2. The substrate processing apparatus according to claim 1, further comprising an instructor configured to instruct creation of a copied image that is a captured image of the first screen,
wherein the at least one piece of related information is the copied image of the first screen created in response to an instruction from the instructor.

3. The substrate processing apparatus according to claim 1, wherein the at least one piece of related information includes a plurality of pieces of related information,
wherein the substrate processing apparatus further comprises a memory configured to store the plurality of pieces of related information, and
wherein the controller is further configured to be capable of reading the at least one piece of related information from the memory and be capable of displaying the at least one piece of related information thus read on the at least one second screen.

4. The substrate processing apparatus according to claim 1, wherein the at least one piece of related information is a captured image of at least a partial area of the first screen, or
wherein the at least one piece of related information is information indicating an alarm content regarding the substrate processing apparatus, or information describing an item displayed on the first screen.

5. The substrate processing apparatus according to claim 1, wherein the controller is further configured to be capable of displaying at least one selected from the group of the at least one second screen and the at least one piece of related information on an enlarged scale or a reduced scale.

6. The substrate processing apparatus according to claim 1, wherein the at least one second screen includes a button to receive an operation by a user touch and instruct movement of the at least one second screen.

7. The substrate processing apparatus according to claim 1, wherein the first screen is capable of displaying recipe information that defines a substrate processing condition, and
wherein the at least one piece of related information is sub-recipe information or main recipe information linked to the recipe information, or
wherein the first screen is capable of displaying parameter information of the substrate processing apparatus, and
wherein the at least one second screen is capable of displaying comparative parameter information to be compared with the parameter information.

8. The substrate processing apparatus according to claim 1, wherein the controller is further configured to be capable of setting a plurality of authorities for the apparatus information, and setting a browsing or operation authority for the apparatus information for each set authority.

9. The substrate processing apparatus according to claim 1, wherein the controller is further configured to be capable of adding new information to the at least one piece of related information displayed on the at least one second screen.

10. The substrate processing apparatus according to claim 1, wherein the at least one piece of related information displayed on the at least one second screen is text information or monitor data indicating an operational status of the substrate processing apparatus.

11. The substrate processing apparatus according to claim 1, wherein the first screen is capable of displaying a monitor data name that is a name of monitor data indicating an operational status of the substrate processing apparatus and a plurality of items regarding the monitor data name, and
wherein the at least one second screen is capable of displaying the monitor data name and at least one item among the plurality of items or a list of the monitor data name.

12. A method of processing a substrate, comprising:
operating a first screen capable of displaying or operating apparatus information that is used in a substrate processing apparatus while at least one second screen capable of displaying at least one piece of related information which is related to the apparatus information is displayed on the first screen; and
loading the substrate into the substrate processing apparatus with the operated first screen.

13. A method of manufacturing a semiconductor device, comprising the method according to claim 12.

14. A program that causes a substrate processing apparatus to perform each process of the method according to claim 12.

15. A control apparatus comprising a controller configured to be capable of operating a first screen capable of displaying or operating apparatus information that is used in a substrate processing apparatus while at least one second screen capable of displaying at least one piece of related information which is related to the apparatus information is displayed on the first screen.
